# EUROPÄISCHE PATENTANMELDUNG

(11) **EP 2 378 448 A2**
(43) Veröffentlichungstag der Anmeldung: **19.10.2011**
(21) Anmeldenummer: 11162430.0
(22) Anmeldetag: 14.04.2011
(51) Int. Cl.: G06F 17/50

(54) **Verfahren zur Vernetzung einer Bauteilgeometrie**

(30) Priorität: 16.04.2010 DE 102010027887
(71) Anmelder: EDAG GmbH & Co. KGaA, 36039 Fulda (DE)
(72) Erfinder: Benninger, Armin, 70825 Korntal-Münchingen (DE)
(74) Vertreter: Schwabe - Sandmair - Marx

(57) **Zusammenfassung**

Verfahren zur Vernetzung einer durch maschinell verarbeitbare Geometriedaten (G) repräsentierten CAD-Urgeometrie (C) eines Bauteils in einem Computersystem, das einen Vernetzungsprozessor (2) zur maschinellen Generierung eines Netzes (Nᵢ) mit finiten Elementen (FE) oder eine Schnittstelle für maschinellen Datenaustausch mit einem externen Vernetzungsprozessor, eine Auswertungseinrichtung (3-6) zur maschinellen Datenverarbeitung und eine Datenspeichereinrichtung aufweist, mit wenigstens den folgenden Verfahrensschritten:
(a) dem Vernetzungsprozessor (2) werden Vernetzungsparameter (L_{target}) und die Geometriedaten (G) vorgegeben,
(b) der Vernetzungsprozessor (2) generiert aus den Geometriedaten (G) unter Berücksichtigung der Vernetzungsparameter (L_{target}) mehrere Netze (Nᵢ) mit finiten Elementen (FE) jeweils in Form maschinell verarbeitbarer Netzdaten,
(c) die Auswertungseinrichtung (3-6) vergleicht die generierten Netze (Nᵢ) jeweils mit einer für das Bauteil erstellten Referenzgeometrie (R), vorzugsweise einer aus der Urgeometrie (C) durch Vereinfachung derselben erstellten Referenzgeometrie (R),
(d) ermittelt für jedes der Netze (Nᵢ) aus dem Vergleich Geometrieabweichungen (ΔGᵢⱼ) von der Referenzgeometrie (R)
(e) und bildet für jedes der Netze (Nᵢ) aus dessen Geometrieabweichungen (ΔGᵢⱼ) einen das Ausmaß der Geometrieabweichungen (ΔGᵢⱼ) des jeweiligen Netzes (Nᵢ) kennzeichnenden Geometriegütewert (SDGᵢ),
(f) die Auswertungseinrichtung (3-6) ermittelt für Elemente (FE) jedes der Netze (Nᵢ) die Größe einer Elementabweichung (ΔEᵢₖ) von wenigstens einem als Vergleichswert (L_{target}, S_{target}, Wₘₐₓ) vorgegebenen Elementkriterium,
(g) bildet für jedes der Netze (Nᵢ) aus dessen Elementabweichungen (ΔEᵢₖ) einen das Ausmaß der Elementabweichungen (ΔEᵢₖ) des jeweiligen Netzes (Nᵢ) kennzeichnenden Elementkriteriengütewert (SDEᵢ)
(h) und speichert die Paare der Geometrie- und Elementkriteriengütewerte (SDGᵢ, SDEᵢ) unter Zuordnung zum jeweils zugehörigen Netz (Nᵢ) in der Datenspeichereinrichtung für eine weitere maschinelle Auswertung oder eine maschinelle Ausgabe auf ein Ausgabemedium.

## Beschreibung

Die Erfindung betrifft ein Verfahren zur Vernetzung einer Geometrie eines Bauteils in einem Computersystem, wobei die Bauteilgeometrie durch vom Computersystem maschinell verarbeitbare Geometriedaten repräsentiert wird. Die Erfindung betrifft ein im Computersystem ausführbare Verfahren, ein Computersystem, in dem das Verfahren ausführbar implementiert ist, das Verfahren während der Ausführung im Computersystem, das Computersystem während der Ausführung des Verfahrens, ein Speichermedium mit dauerhaft oder nur temporär gespeichertem Programmcode zur Ausführung des Verfahrens, ein sogenanntes Computerprogrammprodukt, und auch einen Programmcode zur Ausführung des Verfahrens in gespeicherter Form oder während einer maschinellen Datenübertragung.

Karosseriebauteile und andere strukturell ausgedehnte oder aus anderen Gründen mechanisch komplexe Bauteile werden mit Hilfe des Computers, dem sogenannten Computer Aided Design (CAD) konstruiert. Vor der physikalischen Konstruktion des betreffenden Bauteils und auch diese begleitend werden die im Betrieb zu erwartenden statischen und dynamischen Lastfälle auf der Basis der CAD-Geometrie simuliert, im allgemeinen mittels der Finite-Elemente-Methode (FEM). Für die Simulation mittels einer Finite-Elemente-Methode muss die CAD-Geometrie vernetzt werden. Aus der CAD-Geometrie wird ein der jeweiligen Finite-Elemente-Methode angepasstes Netz aus finiten Elementen generiert. In dem Prozess der Generierung finden Anpassungen, insbesondere auch Glättungen statt, um zwischen benachbarten finiten Elementen für die Simulation ausreichend gleichmäßige Übergänge zu erhalten. Das generierte, für die Finite-Elemente-Methode geeignete Netz ist ein Kompromiss zwischen dem Wunsch nach möglichst großer Geometrietreue und dem Erfordernis der Eignung für die FEM-Computersimulation. Die verfügbaren Vernetzungsprogramme (Batch-Mesher) leisten zwar grundsätzlich die Vernetzung auch geometrisch komplexer Bauteile in einer für die Simulation mittels Finite-Elemente-Methoden geeigneten Weise, allerdings mit in vielen Fällen wegen ungünstiger Parametrierung nur unzureichender Geometrietreue. Das vom jeweiligen Vernetzungsprozessor, der Kombination aus Hardware und darin implementiertem Vernetzungsprogramm, generierte Netz muss daher nachbearbeitet werden, um beispielsweise durch Glättungsprozesse entfallene, aber für das Bauteil mechanisch wesentliche Kanten der CAD-Geometrie wieder so einzufügen, dass das vom Vernetzungsprozessor generierte und anschließend nachbearbeitete Netz für die Simulation mittels Finite-Elemente-Methoden immer noch geeignet ist. Die Nachbearbeitung ist zeitraubend und erfordert fachlich versiertes Personal, das nicht nur mit den einschlägigen Computerprogrammen umgehen kann, sondern auch das erforderliche Hintergrundwissen über das physikalische Bauteil verfügt

Es ist eine Aufgabe der Erfindung, die computergestützte Vernetzung einer CAD-Geometrie eines Bauteils so zu verbessern, dass mittels des Computers ein für Finite-Elemente-Simulationen geeignetes Netz mit erhöhter Geometrietreue generiert wird, das nur noch einer verringerten, vorzugsweise keiner manuellen Nachbearbeitung mehr bedarf.

Die Erfindung hat demgemäß ein Verfahren zur Vernetzung einer durch maschinell verarbeitbare Geometriedaten repräsentierten CAD-Geometrie eines Bauteils in einem Computersystem zum Gegenstand. Die ursprüngliche, im Computersystem verfügbare CAD-Geometrie kann insbesondere eine durch computergestützte Konstruktion erzeugte, neue CAD-Geometrie sein. Sie kann auch durch ein Vermessen eines bereits existierenden Bauteils und Umwandlung und Verarbeitung der Messdaten oder händische Eingabe erzeugt werden. Diese Geometrie wird im folgenden als CAD-Ursprungsgeometrie oder einfach als Ursprungsgeometrie bezeichnet. Das Computersystem umfasst entweder bereits selbst einen Vernetzungsprozessor, also ein ablauffähiges Vernetzungsprogramm, zur maschinellen Generierung eines Netzes finiter Elemente, oder zumindest eine Schnittstelle für einen maschinellen Datenaustausch mit einem im Verhältnis zum Computersystem externen Vernetzungsprozessor, beispielsweise eine USB-Schnittstelle oder eine Schnittstelle für drahtlosen Datentransfer. Das Computersystem umfasst jedenfalls eine mit dem Vernetzungsprozessor oder der Schnittstelle gekoppelte Auswertungseinrichtung für die maschinelle Verarbeitung der vom Vernetzungsprozessor generierten Netzdaten und eine mit der Auswertungseinrichtung gekoppelte Datenspeichereinrichtung, vorzugsweise auch für diese Netzdaten. Maschinell verarbeitbare Daten können insbesondere elektronische oder optische Daten sein, maschinelle Datenverarbeitung oder maschineller Datentransfer können somit insbesondere eine elektronische oder optische Datenverarbeitung bzw. elektronischen oder optischen Datentransfer bezeichnen.

Dem Vernetzungsprozessor werden Vernetzungsparameter in Form von für die finiten Elemente angestrebten Zielwerten oder einzuhaltenden Grenzwerten und die Geometriedaten der Urgeometrie vorgegeben. Es können auch noch weitere Vernetzungsparameter, die nicht auf die Elemente als solche bezogen sind, vorgegeben werden. Die Geometriedaten können insbesondere Datentrippel enthalten oder aus solch bestehen, die in einem dreidimensionalen Koordinatensystem der Urgeometrie die Ortskoordinaten von Punkten der Urgeometrie sind und Strukturlinien der Urgeometrie bestimmen. Strukturlinien der Urgeometrie können stattdessen oder zusätzlich beispielsweise aber auch in Form von Linien oder zu Linien zusammengesetzten Linienabschnitten funktional vorgegeben sein. Als Vernetzurngsparameter kommt insbesondere eine Ziel-Kantenlänge der finiten Elemente des zu generierenden Netzes in Frage, grundsätzlich soll dieser Parameter jedoch nur als beispielhaft und stellvertretend für andere oder bevorzugt weitere Vernetzungsparameter angesehen werden. Die finiten Elemente können Volumenelemente sein, bevorzugter jedoch sind sie Flächenelemente, so dass die Teilbereiche Teilflächen des jeweiligen Elements sind. Die Elemente oder ein Teil der Elemente kann oder können ebene Elemente sein, ein Teil oder alle Elemente kann jeweils oder können aber auch gewölbt und dementsprechend in sich verwunden sein. Ihre Berandungen sind vorzugsweise gerade. Im Falle gewölbter Flächenelemente kann das jeweilige gewölbte Flächenelement in ebene Teilflächen zerlegt und jede der Teilflächen durch eine Flächennormale repräsentiert werden.

Der Vernetzungsprozessor generiert aus den Geometriedaten unter Berücksichtigung der Vernetzungsparameter mehrere unterschiedliche Netze finiter Elemente jeweils in Form maschinell verarbeitbarer Netzdaten. Bei den Netzdaten kann es sich insbesondere um die Ortskoordinaten der Knotenpunkte des jeweiligen Finite-Elemente-Netzes handeln. Obgleich durchaus bereits die Generierung nur weniger Netze, etwa nur von zwei, drei oder vier Netzen, genügen kann, wird vorzugsweise eine Vielzahl von Netzen generiert. Vorzugsweise werden wenigstens zwanzig, noch bevorzugter wenigstens dreißig Netze generiert.

Der Auswertungseinrichtung werden Qualitätskriterien vorgegeben, mit denen die Auswerteeinrichtung die generierten Netze, insbesondere die finiten Elemente der generierten Netze, vergleicht, um die Qualität jedes der generierten Netze zu ermitteln. Da es sich bei den Qualitätskriterien insbesondere um die finiten Elemente beschreibende Kriterien handeln kann, werden die Qualitätskriterien im Folgenden als Elementkriterien bezeichnet. Die Elementkriterien oder ein Teil der Elementkriterien kann oder können auch dem Vernetzungsprozessor vorgegeben werden.

Für die finiten Elemente angestrebte Elementkriterien werden in Form von Vergleichswerten vorgegeben, beispielsweise als maximale Verwindung (warping) oder Zielwert für die Streckung (aspect ratio) oder wieder als Zielkantenlänge. Das Wort "oder" wird hier wie auch sonst von der Erfindung im üblichen logischen Sinne als "inklusiv oder" verstanden, umfasst also sowohl die Bedeutung von "entweder ... oder" als auch die Bedeutung von "und", soweit sich aus dem jeweils konkreten Zusammenhang nicht ausschließlich nur eine dieser beiden Bedeutungen ergeben kann. Bezogen auf die Vorgabe der Elementkriterien bedeutet dies, dass von den beispielhaft angegebenen Elementkriterien entweder nur eines, oder nur eine Auswahl aus den Kriterienbeispielen oder alle genannten Kriterienbeispiele vorgegeben werden können. In vielen Anwendungen werden der Auswertungseinrichtung zwanzig, dreißig oder noch mehr unterschiedliche Elementkriterien vorgegeben. Die Verwindung charakterisiert die Neigung, unter der zwei aneinander stoßende Teilbereiche des jeweiligen finite Elements zueinander weisen. In der Praxis kann die Verwindung insbesondere der Winkel sein, den eine Flächennormale des einen und eine Flächennormale des anderen der beiden Elementteilbereiche miteinander einschließen.

In vielen Anwendungen werden dem Vernetzungsprozessor mehrere, oftmals eine Vielzahl, beispielsweise 20, 30 oder noch mehr unterschiedliche Vernetzungsparameter vorgegeben. Für den Fall, dass nicht alle Zielwerte zugleich von jedem der finiten Elemente eines Netzes erfüllt werden können, kann der Vernetzungsprozessor in Bezug auf einen oder mehrere der unterschiedlichen Vernetzungsparameter von dem jeweiligen Zielwert abweichen. Eine Möglichkeit der Zulassung von Abweichungen in definierter Form besteht beispielsweise darin, eine Obergrenze für die Anzahl der Elemente vorzugeben, die vom jeweiligen Zielwert abweichen dürfen. Als Obergrenze kann beispielsweise vorgegeben werden, dass maximal 5 % oder 10 % aller finiten Elemente des generierten Netzes von einem bestimmten Zielwert, beispielsweise einer vorgegebenen Zielkantenlänge abweichen dürfen. Zulässige Abweichungen können sich aber auch anderweitig beispielsweise alleine aufgrund der Vorgabe der Vernetzungsparameter oder Elementkriterien ergeben, so etwa, falls ein Vernetzungsprozessor oder Elementkriterium als unumstößlich einzuhaltender Wert vorgegeben wird.

Die Auswertungseinrichtung vergleicht maschinell automatisch die generierten Netze jeweils mit einer für das Bauteil erstellten Referenzgeometrie und ermittelt maschinell für jedes der generierten Netze aus dem Vergleich Geometrieabweichungen von der Referenzgeometrie, die für den Vergleich stets die gleiche ist, und erzeugt die geometrischen Abweichungen repräsentierende Geometrieabweichungsdaten. Die Referenzgeometrie kann, obgleich weniger bevorzugt, händisch durch manuelle Eingabe erzeugt werden. Sie kann alternativ auch durch Vermessen, beispielsweise mittels eines berührungslosen oder auf Kontakt beruhenden Abtastverfahrens, des physikalischen Bauteils oder eines Prototypen des Bauteils und vorzugsweise maschinelle Umwandlung der Messdaten erzeugt werden. Als Referenzgeometrie kann auch unmittelbar die Urgeometrie verwendet werden. Bevorzugt wird die Referenzgeometrie durch Vereinfachung der Urgeometrie und somit aus der Urgeometrie erhalten.

Die Auswertungseinrichtung bildet für jedes der generierten Netze aus dessen Geometrieabweichungen, d. h. aus den Geometrieabweichungsdaten, einen das Ausmaß der Geometrieabweichungen des jeweiligen Netzes im Ganzen kennzeichnenden Geometriegütewert. Es ist zu erwarten, dass jedes der generierten Netze an zumindest einem Teil seiner Knotenpunkte mit der Referenzgeometrie nicht exakt in Deckung ist und somit jedes der generierten Netze eine Vielzahl von Geometrieabweichungen von der für alle Netze gleichen Referenzgeometrie aufweist. Die Auswertungseinrichtung verdichtet die Geometrieabweichungen für jedes der Netze zu wenigen, vorzugsweise nur einen einzigen Geometriegütewert. Denkbar ist aber auch die Verdichtung auf zwei, drei oder vier Geometriegütewerte. Der wenigstens eine, vorzugsweise genau eine Geometriegütewert charakterisiert das jeweilige Netz in Bezug auf dessen Geometrietreue im Ganzen.

Die Auswertungseinrichtung ermittelt ferner maschinell automatisch für jedes der generierten Netze das Ausmaß, in dem die finiten Elemente des jeweiligen Netzes von den vorgegebenen Vergleichswerten der Elementkriterien abweichen. So kann es aufgrund der Mehrzahl der vorgegebenen Vernetzungsparameter oder Elementkriterien vorkommen, dass nicht alle Zielwerte zugleich eingehalten werden können und der Vernetzungsprozessor von einem oder mehreren der Zielwerte bei einem oder mehreren der Elemente des jeweiligen Netzes abweichen muss, um trotz eines auftretenden Zielkonflikts überhaupt ein vollständiges Netz generieren zu können. Wird für eines oder mehrere der Elementkriterien als Vergleichswert ein Grenzwert eingegeben, beispielsweise eine maximale Streckung oder eine maximale Verwindung, so werden als Abweichungen nur Unterschreitungen eines als Untergrenze und Überschreitungen eines als Obergrenze angegebenen Vergleichswerts angesehen. Die Abweichungen werden vorzugsweise jeweils mit dem gleichen Vorzeichen, beispielsweise jeweils nur mit positivem Vorzeichen berücksichtigt. Die Auswertungseinrichtung bildet für jedes der generierten Netze einen das Ausmaß der elementweise Abweichungen insgesamt charakterisierenden Elementkriteriengütewert. Der Elementkriteriengütewert ist ein Maß für den Grad der Eignung des jeweiligen Netzes für die FEM-Simulation. Er charakterisiert den Eignungsgrad des jeweiligen Netzes global, im Ganzen.

Um den Elementkriteriengütewert zu bestimmen, ermittelt die Auswertungseinrichtung für einen größeren Teil der finiten Elemente, vorzugsweise für alle finiten Elemente des jeweiligen Netzes, Elementabweichungen von wenigstens einem der vorgegebenen Vergleichswerte. Vorzugsweise werden die Elementabweichungen für jeden der mehreren vorgegebenen Vergleichswerte ermittelt. So können beispielsweise für jedes der ausgewählten oder vorzugsweise alle Elemente des jeweiligen Netzes jeweils eine tatsächliche Kantenlänge des jeweiligen Elements mit dem für beispielsweise die Kantenlänge als Kriterium vorgegebenen Vergleichswert oder eine Verwindung der ausgewählten oder aller Elemente ermittelt und mit dem für das Elementkriterium der Verwindung vorgegebenen Vergleichswert verglichen werden. Die Elementabweichungen können insbesondere als Differenzen der für die Elemente erhaltenen Elementwerte und des der Art nach jeweils gleichen Kriterium-Vergleichswerts gebildet werden. Für die ausgewählten oder alle finiten Elemente des jeweiligen Netzes wird vorzugsweise ein vollständiger Kriterienvergleich durchgeführt. Bezogen auf die beispielhaft angeführten Elementkriterien der Kantenlänge, Verwindung und Streckung bedeutet dies, dass die Länge jeder der Kanten des jeweiligen Elements mit dem vorgegebenen Längenvergleichswert, eine ermittelte Verwindung des jeweiligen Elements mit dem Verwindungsvergleichswert und eine ermittelte Streckung des jeweiligen Elements mit dem Vergleichswert des Kriteriums der Streckung verglichen und somit für jedes untersuchte finite Element ein Datensatz von Elementabweichungen erzeugt wird. Vorzugsweise werden die Elementabweichungen der einzelnen Elemente zu einem einzigen, für das jeweilige Element charakteristischen Elementkennwert verdichtet, also aus den mehreren Elementabweichungen für das jeweilige Element ein einziger Elementkennwert für dieses Element gebildet. Aus den Elementabweichungen aller untersuchten finiten Elemente des jeweiligen Netzes wird durch einen implementierten Verdichtungsprozess der für das jeweilige Netz im Ganzen charakteristische Elementkriteriengütewert gebildet. Der Elementkriteriengütewert kann beispielsweise einfach die Summe aller Elementabweichungen oder der optional ermittelten Elementkennwerte der einzelnen Elemente sein, er kann bevorzugter auch als Mittelwert, beispielsweise arithmetischer oder geometrischer oder gewichteter Mittelwert aller Elementabweichungen oder Elementkennwerte gebildet werden. Bevorzugt wird der Elementkriteriengütewert aus den Elementabweichungen oder den bereits elementweise verdichteten Elementkennwerten der Elemente als Standardabweichung gebildet.

Der Geometriegütewert, pro Netz vorzugsweise nur ein einziger Geometriegütewert, und der Elementkriteriengütewert, pro Netz vorzugsweise nur ein einziger Elementkriteriengütewert, werden für jedes der Netze, die Gütewertepaare also unter Zuordnung zum jeweils zugehörigen generierten Netz, in der Datenspeichereinrichtung für eine weitere maschinelle Auswertung innerhalb des Computersystems oder in einem nachgeordneten Computersystem oder eine maschinelle Ausgabe auf ein Ausgabemedium des Computersystems oder eines nachgeordneten Computersystems gespeichert. Das Verfahren liefert somit die generierten unterschiedlichen Netze in Form jeweils von Netzdaten und für jedes dieser Netze einen, vorzugsweise nur einen einzigen die Geometrietreue zur Referenzgeometrie charakterisierenden Geometriegütewert und einen, vorzugsweise nur einen einzigen den Eignungsgrad für die Finite-Elemente-Simulation charakterisierenden Elementkriteriengütewert. Die Verdichtung auf die globalen Gütewerte erleichtert die Auswahl eines optimalen Netzes unter den generierten Netzen oder zumindest die Ausscheidung der weniger geeigneten, unterlegenen Netze und Identifizierung der geeigneteren, überlegenen Netze.

In einer Weiterbildung ermittelt die Auswertungseinrichtung maschinell durch Vergleich der Geometriegütewerte und Elementkriteriengütewerte automatisch diejenigen der generierten Netze, die sowohl einen schlechteren Geometriegütewert als auch einen schlechteren Elementkriteriengütewert als wenigstens ein anderes der generierten Netze haben. Es versteht sich, dass beim Vergleich zweier Netze die Geometriegütewerte dieser Netze miteinander und die Elementkriteriengütewerte miteinander verglichen werden. Durch den Vergleich wird somit jedes Netz identifiziert, das einen Geometriegütewert und einen Elementkriteriengütewert aufweist, die nicht beide zugleich schlechter sind als der Geometriegütewert und der Elementkriteriengütewert irgend eines anderen der Netze. Diese, nicht in ihren beiden Gütewerten zugleich von einem der anderen Netze übertroffenen Netze werden als favorisierte Netze gekennzeichnet. Im Idealfall existiert ein einziges favorisiertes Netz. In den meisten Fällen wird der Vergleich jedoch mehrere im genannten Sinne favorisierte Netze liefern. Werden vom Vernetzungsprozessor in automatisierter Sequenz oder mittels mehrerer Vernetzungsprozessoren parallel auf der Basis jeweils der Grenzwerte der Elementkriterien aus den Geometriedaten Netze in ausreichend großer Anzahl generiert, kann mittels des Auswahlverfahrens nach der Methode von Pareto die Anzahl der favorisierten Netze so stark eingeschränkt werden, dass die Auswahl eines am stärksten zu favorisierenden und deshalb für die FEM-Simulation zu verwendenden Netzes nicht mehr schwer fällt.

In bevorzugten Ausführungen ordnet das Computersystem die generierten Netze, repräsentiert durch den Geometriegütewert und den Elementkriteriengütewert des jeweiligen Netzes, in einem Koordinatensystem, vorzugsweise in einem zweidimensionalen Koordinatensystem, einem Diagramm, mit dem Geometriegütewert als eine Koordinatenachse und dem Elementkriteriengütewert als einer anderen Koordinatenachse an und stellt das Koordinatensystem mit den die Netze repräsentierenden Gütewertepaaren grafisch auf einem Bildschirm oder Druckmedium dar. In solch einer Pareto-Darstellung sind die im vorstehenden Sinne favorisierten Netze leicht erkennbar, sie bilden eine Pareto-Front. Sie können optisch kenntlich gemacht werden, beispielsweise farblich. Wird im Rahmen des Verfahrens der vorstehend erläuterte Vergleich durchgeführt, so kann das Verfahren auch so gestaltet sein, dass in dem Koordinatensystem nur die favorisierten Netze in Form jeweils des zugehörigen Gütewertepaars angeordnet und dargestellt werden. Unter den gegebenenfalls mehreren favorisierten Netzen kann das am meisten zu favorisierende und daher auszuwählende Netz beispielsweise als dasjenige Netz identifiziert werden, dessen Gütewertepaar von einem Nullpunkt des Koordinatensystems den geringsten Abstand aufweist. Diese Auswahl kann vorteilhafterweise ebenfalls maschinell automatisiert durch das Computersystem oder ein nachgeordnetes Computersystem im Rahmen des Verfahrens geleistet werden. Das Gütewertepaar mit dem geringsten Abstand vom Ursprung des Koordinatensystems kann in einer optischen Darstellung auch besonders kenntlich gemacht werden, beispielsweise farblich.

Das Verfahren kann dafür eingerichtet sein, alle generierten Netze und die zugehörigen Gütewerte mit entsprechender, vorzugsweise bijektiver Zuordnung in der Datenspeichereinrichtung des Computersystems zu halten. In der Weiterbildung, in der im Rahmen des Verfahrens durch das Computersystem oder ein nachgeordnetes Computersystem die favorisierten Netze maschinell identifiziert werden, können die durch den Vergleich als unterlegen identifizierten Netze, also deren Netzdaten, sowie deren Gütewertepaare auch jeweils nach der Identifizierung gelöscht oder zumindest vom weiteren Vergleich oder der optionalen grafischen Darstellung ausgenommen werden.

Als Vernetzungsprozessor kann wie bereits erwähnt einer der üblichen Standard-Vernetzungsprozessoren verwendet werden, dem die Vernetzungsparameter in Form von Ziel- oder Grenzwerten vorgegeben werden und der als eine Art Blackbox betrachtet werden kann, die aus dem gleichen Satz von vorgegebenen Parametern bei jedem Lauf jeweils ein anderes Netz automatisch unter Berücksichtigung der vorgegebenen Vernetzungsparameter generiert. Der Vernetzungsprozessor, ob Standardvernetzungsprozessor oder eigens programmierter Vernetzungsprozessor, kann beispielsweise in vorgegebener, d. h. determinierter, oder mittels Zufallsgenerator erzeugter Variation die Vernetzungsparameter, vorzugsweise innerhalb eines durch vorgegebene Grenzwerte bestimmten Rahmens, variieren und somit unterschiedliche Sätze von Vernetzungsparametern automatisch selbst erzeugen und dann das jeweilige Netz basierend auf dem jeweiligen Satz der variierten Parameter generieren.

Um die unterschiedlichen Sätze der Vernetzungsparameter zu erzeugen, kann das Computersystem einen, mehrere oder alle der Parameter unter Einhaltung vorgegebener Grenzwerte maschinell automatisch, also ohne manuellen Eingriff, variieren. Die variierten Werte der Vernetzungsparameter können mittels eines Zufallgenerators erzeugt werden, über den der Vernetzungsprozessor verfügen kann. Ein Zufallsgenerator oder ein Parameterwertgenerator anderer Art kann im Computersystem zusätzlich eigens für das Verfahren programmiert sein, zusätzlich zu einem von Hause aus vorhandenen Parameterwertgenerator oder stattdessen, falls ein solcher nicht vorhanden ist, um automatisch die unterschiedlichen Sätze der Vernetzungsparameter zu erzeugen und diese Sätze variierter Parameter jeweils in Form maschinell verarbeitbarer Daten dem Vernetzungsprozessor oder mehreren parallelen Vernetzungsprozessoren mittels maschinellem Datentransfer automatisch aufzugeben. Der Vernetzungsprozessor behandelt die variierten Werte der Vernetzungsparameter bei der Generierung des jeweiligen Netzes als dessen Parameter.

Die Referenzgeometrie, gegen die die Geometrieabweichungen der generierten Netze ermittelt werden, kann zwar grundsätzlich extern erstellt und dem Computersystem aufgespielt werden, in bevorzugten Ausführungen umfasst das Computersystem jedoch einen Strukturanalysator, dem die Geometriedaten der Urgeometrie aufgegeben werden. Der Strukturanalysator erzeugt durch maschinelle Verarbeitung der Geometriedaten die im Vergleich zur Urgeometrie vereinfachte Referenzgeometrie. Eine Vereinfachung wird vorzugsweise dadurch vorgenommen, dass Strukturlinien der Urgeometrie, die das statische oder dynamische Verhalten der das physikalische Bauteil in der Simulation vertretenden Urgeometrie nicht maßgeblich beeinflussen, durch den Strukturanalysator im Rahmen der Vereinfachung geglättet werden, was bis zu einer Einebnung vernachlässigbarer Kanten führen kann.

Der Strukturanalysator arbeitet vorzugsweise als Strukturkantenanalysator, indem er die durch die Geometriedaten bestimmten Kanten abfährt, wobei die erwähnten Strukturlinien der Urgeometrie diese Kanten bilden. Für die Kanten, respektive Strukturlinien, wird jeweils die Größe einer lokalen Neigung der Urgeometrie ermittelt, entweder jeweils eine einzige oder mehrere lokale Neigung(en) pro Kante. Die lokale Neigung ist ein Maß dafür, wie spitz oder stumpf zwei Flächen an einer Strukturlinie der Urgeometrie zueinander weisen. Die lokale Neigung kann insbesondere der Winkel sein, den eine Flächennormale der einen und eine Flächennormale der anderen der beiden Flächen miteinander einschließen. Vorzugsweise werden sämtliche Kanten der Urgeometrie abgefahren und für jede der Kanten eine lokale Neigung ermittelt. Aus den lokalen Neigungen bildet der Strukturanalysator einen für die gesamte Urgeometrie charakteristischen globalen Kantenwert. Der Strukturanalysator vergleicht ferner die lokalen Neigungen mit dem globalen Kantenwert und übernimmt für die Referenzgeometrie von den abgefahrenen Kanten nur diejenigen, an denen die lokale Neigung wenigstens so groß wie der globale Kantenwert ist. Der globale Kantenwert kann beispielsweise die Summe oder bevorzugter ein Mittelwert, beispielsweise das arithmetische Mittel der lokalen Neigungen sein, er kann aber beispielsweise auch das arithmetische Mittel multipliziert mit einem Faktor ungleich 1 sein. Der globale Kantenwert dient als Maßstab für die Bedeutung der jeweiligen Kante für das mechanische Verhalten des physikalischen Bauteils. Ist die lokale Neigung der betreffenden Kante wenigstens so groß wie der globale Kantenwert, wird die Kante als strukturell bedeutend eingestuft und in der Referenzgeometrie beibehalten. Unterschreitet die lokale Neigung den globalen Kantenwert, so schließt der Strukturanalysator, dass die betreffende Kante für das statische oder dynamische, jedenfalls das zu simulierende Verhalten des Bauteils so unmaßgeblich ist, dass sie für das Referenznetz vernachlässigt werden kann und im Referenznetz nicht repräsentiert sein muss. Eine im Vergleich mit der Urgeometrie auf die strukturell nur wesentlichen Kanten reduzierte Referenzgeometrie erleichtert die Ermittlung der Geometrieabweichungen der generierten Netze erheblich und fokussiert die Geometrieabweichungen auch auf die für die mechanischen Eigenschaften des zu simulierenden Bauteils tatsächlich wesentlichen geometrischen Abweichungen.

Obgleich zur Erzeugung der Referenzgeometrie bevorzugterweise ein Strukturkantenanalysator verwendet wird, kann alternativ auch ein Strukturanalysator anderer Art zum Einsatz gelangen, insbesondere im Computersystem implementiert sein. So kann die Urgeometrie alternativ durch eine Eigenfrequenzanalyse, die mit einem hierfür eingerichteten Strukturanalysator durchgeführt wird, auf die für das mechanische Verhalten des Bauteils wesentlichen Strukturlinien reduziert werden. Die Kantenanalyse ist nur ein, wenngleich bevorzugtes Beispiel, der Vergleichsparameter der lokalen Neigungen der an den Strukturlinien, respektive Kanten, aneinanderstoßenden Flächen nur ein, wenngleich bevorzugtes Beispiel für einen Parameter zur Bestimmung wesentlicher Kanten und das Entscheidungskriterium des Überschreitens eines globalen Vergleichsparameterwerts nur ein, wenngleich bevorzugtes Beispiel für ein Entscheidungskriterium zur Ermittlung der mechanisch wesentlichen Strukturlinien der Urgeometrie.

Der Strukturanalysator kann so programmiert sein, dass er längs der Strukturlinien, respektive Kanten, in vorgegebenen Abständen oder in Abständen, die in Abhängigkeit von den Kantenlängen errechnet werden, oder auf in den Geometriedaten unmittelbar enthaltenen Punkten der jeweiligen Strukturlinie jeweils die lokale Neigung der an die jeweilige Kante grenzenden Flächen der Urgeometrie ermittelt. Er kann in einer Variante aber auch so programmiert sein, dass er für jede der abgefahrenen Kanten nur jeweils eine einzige lokale Neigung ermittelt. Für die Bildung des globalen Kantenwerts werden in beiden Varianten vorzugsweise alle der ermittelten lokalen Neigungen verwendet. Für die Entscheidung, ob die betreffende Kante in der Referenzgeometrie repräsentiert wird, kann bei Ermittlung mehrerer lokaler Neigungen längs der gleichen Kante beispielsweise die größte dieser lokalen Neigungen mit dem globalen Kantenwert verglichen werden, falls die Neigung sich längs der Kante ändert. Bei sich längs einer oder mehrerer Kanten ändernder Neigung kann aus den für die jeweils gleiche Kante unterschiedlichen lokalen Neigungen aber beispielsweise auch ein Mittelwert, beispielsweise das arithmetische oder ein gewichtetes Mittel, für den Vergleich mit dem globalen Kantenwert herangezogen werden.

Als die Geometrieabweichungen werden die Abstände ermittelt, die Knotenpunkte oder andere Punkte von Netzlinien der generierten Netze jeweils von der Referenzgeometrie aufweisen. Die Auswertungseinrichtung kann bei jedem der generierten Netze für jeweils jeden der Knotenpunkte oder andere Punkte auf Netzlinien beispielsweise solch eine Geometrieabweichung als Abstand des jeweiligen Knotenpunkts oder anderen Punkts zu jeweils einem nächstgelegenen Referenzpunkt oder einer nächstgelegenen Referenzlinie der Referenzgeometrie ermitteln. In vereinfachten Ausführungen wird eine Geometrieabweichung nicht für jeden Knotenpunkt oder jede Netzlinie des jeweiligen generierten Netzes ermittelt, sondern nur für einen größeren Teil der Knotenpunkte oder Netzlinien, wobei die Anzahl der Knotenpunkte oder Netzlinien, für die jeweils die Geometrieabweichung ermittelt wird, jedenfalls so groß gewählt wird, dass diese ausgewählten Knotenpunkte oder Netzlinien das jeweilige Netz in Bezug auf die zu beurteilende Geometrietreue ausreichend detailliert repräsentieren. In bevorzugten Ausführungen ermittelt die Auswertungseinrichtung von den Referenzlinien der Referenzgeometrie ausgehend, ob im jeweils untersuchten Netz diese Referenzlinie repräsentiert ist, ob also Knotenpunkte des jeweils untersuchten Netzes eine Netzlinie bestimmen, die der jeweils betrachteten Referenzlinie am nächsten ist und im generierten Netz diese Referenzlinie daher ersetzt. Fällt diese durch die betreffenden Knotenpunkte bestimmte Netzlinie mit der Referenzlinie zusammen, existiert für die betrachtete Referenzlinie keine Geometrieabweichung. Wird eine vollständige Überdeckung nicht festgestellt, weist also wenigstens einer der Punkte, insbesondere der Knotenpunkte, der nächstgelegenen Netzlinie einen Abstand von der untersuchten Referenzlinie auf, ermittelt die Auswertungseinrichtung diesen Abstand als eine der Geometrieabweichungen. Für Knotenpunkte, die im Rahmen des Vergleichs nicht als Knotenpunkte identifiziert werden, die eine die jeweils untersuchte Referenzlinie repräsentierende Ersatzlinie des Netzes bilden, werden Geometrieabweichungen zur Referenzgeometrie vorzugsweise nicht ermittelt, was den Vergleichsprozess mit der Referenzgeometrie vereinfacht und beschleunigt.

Nach Durchführung des Vergleichs hat die Auswertungseinrichtung für jedes der generierten Netze einen Datensatz von Geometrieabweichungen, Geometrieabweichungsdaten, erzeugt, die in einem Speicher der Datenspeichereinrichtung abgelegt und anschließend zum Geometriegütewert des jeweiligen Netzes oder unmittelbar zum Geometriegütewert verarbeitet werden können. Der Geometriegütewert kann beispielsweise einfach die Summe der Geometrieabweichungen des jeweiligen Netzes oder ein Mittelwert, beispielsweise das geometrische oder arithmetische oder ein unter mechanischen Gesichtspunkten gewichtetes Mittel der Geometrieabweichungen sein. In bevorzugten Ausführungen bildet die Auswertungseinrichtung für jedes der Netze aus dessen Geometrieabweichungen die Standardabweichung und verwendet diese Geometriestandardabweichung als den Geometriegütewert.

Die Erfindung findet vorzugsweise im Fahrzeugbau, besonders bevorzugt im Kraftfahrzeugbau, Verwendung. Das Bauteil kann insbesondere eine Rohkarosserie oder ein Karosserieteil einer Rohkarosserie eines Kraftfahrzeugs oder ein Anbauteil wie etwa eine Tür, Motorhaube, Heckklappe, ein Kofferraumdeckel oder Schiebedach eines Kraftfahrzeugs sein. Das Kraftfahrzeug kann ein Nutzfahrzeug oder insbesondere ein Personenkraftfahrzeug sein. Innerhalb des Fahrzeugbaus kann die Erfindung aber auch mit Vorteil für beispielsweise Schienenfahrzeuge, Wasserfahrzeuge, Luftfahrzeuge und auch Raumfahrzeuge Verwendung finden. Die Erfindung ist grundsätzlich auch nicht auf den Fahrzeugbau beschränkt, sondern kann nutzbringend beispielsweise auch für baustatische oder -dynamische Zwecke eingesetzt werden. Grundsätzlich ist sie überall dort von Vorteil, wo strukturell komplexe mechanische Bauteile mittels einer Finite-Elemente-Methode untersucht werden sollen. Sie ist besonders geeignet zur Untersuchung von Schalenstrukturen, also Bauteilen, die im Vergleich zu ihrer Länge und Breite eine deutlich geringere Dicke aufweisen, wie beispielsweise Blechstrukturen, Schalenstrukturen aus Kunststoff und auch Schalenstrukturen aus Verbundwerkstoffen. Die generierten Netze setzen sich in derartigen Verwendungen aus zweidimensionalen finiten Flächenelementen zusammen. Grundsätzlich ist die Erfindung aber auch für volumenhafte Bauteile und dementsprechend zur Generierung von Netzen mit dreidimensionalen finiten Volumenelementen geeignet.

Die Erfindung betrifft das Verfahren insbesondere während der Ausführung durch das Computersystem. Sie betrifft ferner das Verfahren auch als solches sowie einen Programmcode, der auf einem Speichermedium wie beispielsweise einem USB-Stick, einer Festplatte, einer CD oder DVD oder irgendeinem anderen Speichermedium dauerhaft gespeichert ist. Sie betrifft den Programmcode aber auch, sofern dieser drahtlos oder drahtgebunden maschinell übertragen oder in einer für eine derartige Übertragung unmittelbar geeigneten Form bereitgehalten wird. Der Programmcode kann den Programmcode oder einen Teil des Programmcodes des Vernetzungsprozessors enthalten. Der Vernetzungsprozessor wird vorzugsweise allerdings anderweitig verwirklicht, beispielsweise durch einen der am Markt erhältlichen Vernetzungsprozessoren. In derartigen Ausführungen ist der erfindungsgemäße Programmcode an wenigstens einen solchen Vernetzungsprozessor angepasst, um die von solch einem Standard-Pre-Prozessor generierten Netze zu den Geometrie- und Elementkriteriengütewerten, vorzugsweise jeweils ein Gütewertepaar pro generiertem Netz, verdichten zu können. In noch einer Variante ist das Verfahren oder nur ein Teil des Verfahrens in dem Vernetzungsprozessor implementiert. So kann der Vernetzungsprozessor den gesamten Programmcode zur Ausführung des erfindungsgemäßen Verfahrens umfassen oder den gesamten Programmcode mit Ausnahme des Struktur-, vorzugsweise Strukturkantenanalysators, um nur bevorzugte Beispiele für die Integration in einen Vernetzungsprozessor zu nennen.

Die Generierung der Referenzgeometrie und ein dies leistender Strukturanalysator, vorzugsweise Strukturkantenanalysator, sind auch an sich von Vorteil und nicht nur im Zusammenwirken mit oder als Bestandteil der hier beanspruchten Erfindung. So behält es sich die Anmelderin vor, auf den Strukturanalysator, das Verfahren zur Erzeugung einer Referenzgeometrie, die Verwendung der generierten Referenzgeometrie als Vergleichsmaßstab für ein von einem Vernetzungsprozessor erzeugtes Netz oder auf entsprechenden Programmcode, insbesondere auf einem Datenspeichermedium, im Rahmen einer Teilungsanmeldung eigenständig Ansprüche zu richten. Die im Zusammenhang mit der hier beanspruchten Erfindung offenbarten Merkmale sind allerdings je für sich und in jeder offenbarten Kombination auch in Verbindung mit solch einem weiteren Erfindungsgegenstand von Vorteil. Mittels der automatisch erzeugten Referenzgeometrie kann bevorzugt im Rahmen der Erfindung, aber auch in anderen Verfahren ein Vergleich mit einem generierten Netz effizient durchgeführt werden, um zu entscheiden, vorzugsweise automatisiert maschinell, ob das generierte Netz das physische Bauteil in seinen für die Simulation maßgeblichen Eigenschaften ausreichend genau repräsentiert. Gegenstand solch einer Teilungsanmeldung kann daher unter anderem sein ein Verfahren zur Vernetzung einer durch maschinell verarbeitbare Geometriedaten (G) repräsentierten CAD-Urgeometrie (C) eines Bauteils in einem Computersystem, das einen Vernetzungsprozessor (2) zur maschinellen Generierung eines Netzes (Nᵢ) mit finiten Elementen (FE) oder eine Schnittstelle für maschinellen Datenaustausch mit einem externen Vernetzungsprozessor, eine

Auswertungseinrichtung (3-6) zur maschinellen Datenverarbeitung und eine Datenspeichereinrichtung aufweist, mit wenigstens den folgenden Verfahrensschritten:
(a) dem Vernetzungsprozessor (2) werden Vernetzungsparameter (L_{target}) und die Geometriedaten (G) vorgegeben,
(b) der Vernetzungsprozessor (2) generiert aus den Geometriedaten (G) unter Berücksichtigung der Vernetzungsparameter (L_{target}) wenigstens ein Netz (Nᵢ) mit finiten Elementen (FE) in Form maschinell verarbeitbarer Netzdaten,
(c) die Auswertungseinrichtung (3-6) vergleicht das generierte Netz (Nᵢ) mit einer für das Bauteil erstellten Referenzgeometrie (R), vorzugsweise einer aus der Urgeometrie (C) durch Vereinfachung derselben erstellten Referenzgeometrie (R),
(d) ermittelt für das Netz (Nᵢ) aus dem Vergleich Geometrieabweichungen (ΔGᵢⱼ) von der Referenzgeometrie (R)
(e) und bildet für das Netz (Nᵢ) aus dessen Geometrieabweichungen (ΔGᵢⱼ) einen das Ausmaß der Geometrieabweichungen (ΔGᵢⱼ) des Netzes (Nᵢ) kennzeichnenden Geometriegütewert (SDGᵢ).
(f) Optional ermittelt die Auswertungseinrichtung (3-6) für Elemente (FE) des Netzes (Nᵢ) die Größe einer Elementabweichung (ΔEᵢₖ) von wenigstens einem als Vergleichswert (L_{target}, S_{target}, Wₘₐₓ) vorgegebenen Elementkriterium,
(g) bildet für das Netz (Nᵢ) aus dessen Elementabweichungen (ΔEᵢₖ) einen das Ausmaß der Elementabweichungen (ΔEᵢₖ) des jeweiligen Netzes (Nᵢ) kennzeichnenden Elementkriteriengütewert (SDEᵢ)
(h) und speichert das Paar der Geometrie- und Elementkriteriengütewerte (SDGᵢ, SDEᵢ) unter Zuordnung zum Netz (Nᵢ) in der Datenspeichereinrichtung für eine weitere maschinelle Auswertung oder eine maschinelle Ausgabe auf ein Ausgabemedium.

Ein Gegenstand kann auch ein Verfahren zur computergestützten, also maschinell automatisierten Generierung der Referenzgeometrie sein mit den Merkmalen wenigstens eines der Ansprüche 6 und 7 in Kombination mit Anspruch 5, jedoch ohne die Merkmale des Anspruchs 1. Dessen Merkmale können einzeln und in jeder Kombination Gegenstand jeweils von Weiterbildungen sein.

Vorteilhafte Merkmale werden auch in den Unteransprüchen und deren Kombinationen beschrieben.

Nachfolgend wird ein Ausführungsbeispiel der Erfindung anhand von Figuren erläutert. Am Ausführungsbeispiel offenbar werdende Merkmale bilden jeweils einzeln und in jeder Merkmalskombination die Gegenstände der Ansprüche und auch die vorstehend erläuterten Ausgestaltungen vorteilhaft weiter. Es zeigen:
- Figur 1: eine CAD-Urgeometrie eines Bauteils,
- Figur 2: eine aus der Urgeometrie erstellte Referenzgeometrie,
- Figur 3: ein Ablaufdiagramm für ein Verfahren zur Vernetzung der Urgeometrie,
- Figur 4: ein aus Geometriedaten der Urgeometrie generiertes Netz finiter Elemente und die Referenzgeometrie in einer Überlagerung und
- Figur 5: ein Pareto-Diagramm, in dem mehrere im Verfahren generierte Netze jeweils durch ein Paar von Gütewerten repräsentiert sind.

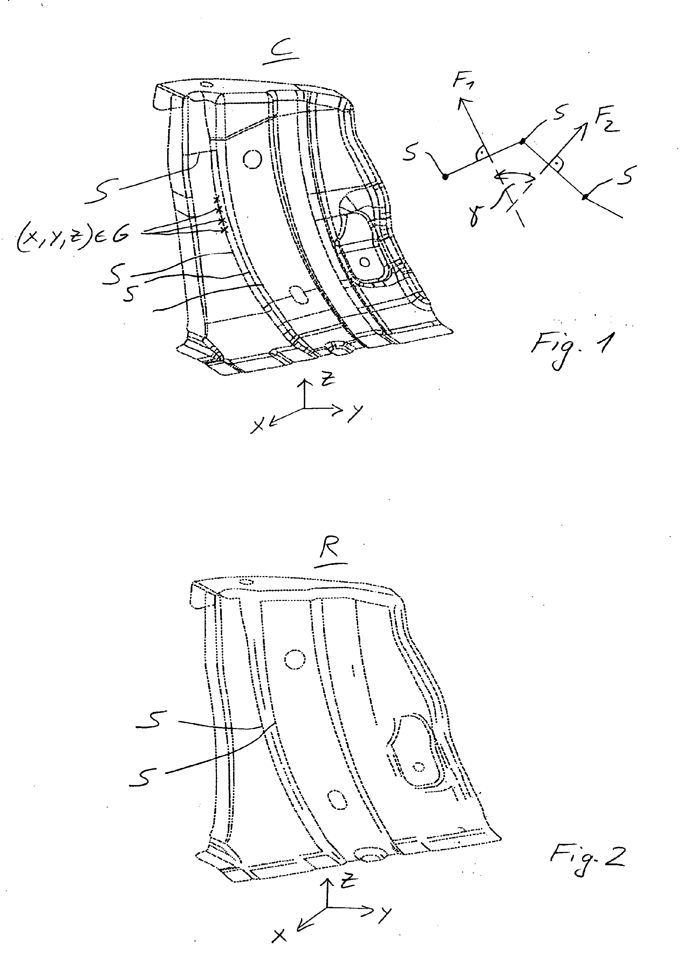

Figur 1 zeigt eine am Computer mittels eines Konstruktionsprogramms konstruierte CAD-Geometrie C eines zumindest im Wesentlichen schalenförmigen Bauteils, beispielsweise eines Karosserieteils oder Anbauteils eines Automobils. Das physikalische Bauteil wird auf der Basis der CAD-Geometrie C gefertigt. Vor der Fertigung oder gegebenenfalls diese begleitend wird das Verhalten des Bauteils unter statischer oder dynamischer Belastung simuliert, beispielsweise das Schwingungsverhalten oder das Crashverhalten. Für die Simulation wird die CAD-Geometrie, im Folgenden auch Urgeometrie C genannt, in ein für Finite-Elemente-Berechnungen geeignetes Finite-Elemente-Netzmodel überführt, also vernetzt. Die Vernetzung (meshing) wird vorzugsweise mit einem der üblicherweise verwendeten Pre-Prozessoren, im folgenden Vernetzungsprozessor, durchgeführt.

Um den nach der Generierung eines Netzes aus finiten Elementen erforderlichen Aufwand für eine manuelle Nachbearbeitung deutlich zu reduzieren oder eine manuelle Nachbearbeitung im Idealfall gänzlich unnötig zu machen, wird in einem computerimplementierten, maschinellen Optimierungsprozess unter vorgegeben Optimierungsbedingungen ein optimales Netz oder eine Gruppe von optimalen Netzen innerhalb einer größeren Anzahl von generierten Netzen identifiziert. Der Vernetzungsgenerator generiert eine Vielzahl von Netzen finiter Elemente, aus denen nach den vorgegebenen Optimierungskriterien - zum einen die Geometrietreue zur Urgeometrie C und zum anderen die Elementkriterientreue zu für die finiten Elemente vorgegebenen Elementkriterien - die Gruppe der optimalen Netze und im Idealfall ein einziges optimales Netz identifiziert wird.

Figur 2 zeigt eine Referenzgeometrie R, die auf der Basis der Urgeometrie C maschinell erstellt wird, Die Referenzgeometrie R enthält von den die Kanten des Bauteils repräsentierenden Strukturlinien S der Urgeometrie C nur die für das mechanische Verhalten des repräsentierten Bauteils relevanten Strukturlinien S als Referenzlinien. Die mechanisch nicht relevanten Strukturlinien S sind unterdrückt, sie können optional geglättet oder eingeebnet sein. In bevorzugten einfachen Ausführungen werden diese mechanisch nicht relevanten Strukturlinien einfach weggelassen. Von den die Geometrie C beschreibenden Geometriedaten G sind entsprechend die zu solch nicht relevanten Strukturlinien S gehörenden Daten in dem die Referenzgeometrie R beschreibenden Datensatz nicht repräsentiert, entweder unterdrückt, falls zur Bereitstellung der Referenzgeometrie R auf den Satz der Geometriedaten G zurückgegriffen wird, oder gelöscht, falls die Referenzgeometrie R in einem Datenspeicher zusätzlich zu dem die Urgeometrie C repräsentierenden vollen Datensatz G gespeichert wird.

Die Referenzgeometrie R wird zumindest im Wesentlichen maschinell automatisch mittels eines computerimplementierten Strukturanalysators erstellt. Für die Erstellung fährt der Strukturanalysator bildlich gesprochen die Strukturlinien S der Urgeometrie ab und entscheidet in Abhängigkeit von wenigstens einem vorgegebenen Kriterium, ob die jeweilige Strukturlinie S für das mechanische Verhalten des physikalischen Bauteils mechanisch relevant ist und daher in der Referenzgeometrie R repräsentiert sein muss oder nicht relevant ist und daher vernachlässigt und in der Referenzgeometrie R weggelassen werden kann. Ergebnis des vom Strukturanalysator ausgeführten Prozesses ist die im Vergleich mit der Urgeometrie C vereinfachte, auf die mechanisch relevanten Strukturlinien S reduzierte Referenzgeometrie R.

Ein vom Strukturanalysator vorzugsweise angewendetes Kriterium für die Identifizierung der relevanten und nicht relevanten Strukturlinien S ist die Neigung, die an der jeweiligen Strukturlinie S zusammenstoßende Flächen der Urgeometrie C zueinander aufweisen. In Figur 1 ist neben der perspektivischen Darstellung der Urgeometrie C ein drei benachbarte Strukturlinien S enthaltender Ausschnitt eines Querschnitts durch die Geometrie C dargestellt. Die drei nebeneinander verlaufenden Strukturlinien S sind durch Punkte angedeutet. Die Verbindungslinien der Querschnittsdarstellung repräsentieren zwischen den Strukturlinien S liegende Flächen der Urgeometrie C. An der mittleren Strukturlinie S stoßen zwei solche Flächen unter Bildung einer Kante aneinander. Die lokale Neigung auf der mittleren Strukturlinie S ist der Winkel γ, den eine Flächennormale F₁ der einen dieser beiden Flächen mit einer Flächennormalen F₂ der anderen Fläche miteinander einschließen. Der Strukturanalysator fährt die Strukturlinien S der Geometrie C ab, indem er in vorgegebenen Abständen die am jeweiligen Ort auf der jeweiligen Strukturlinie S vorhandene lokale Neigung γ ermittelt. Dies geschieht rechnerisch auf der Basis der Geometriedaten G. Der Strukturanalysator summiert die ermittelten lokalen Neigungen γ und bestimmt für die Urgeometrie C im Ganzen eine globalen Kantenwert r, vorzugsweise als Mittelwert der lokalen Neigungen γ, zweckmäßigerweise als arithmetisches Mittel Γ = (Σγ)/n, wobei n die Anzahl der aufsummierten lokalen Neigungen γ ist. Der Strukturanalysator verwendet den globalen Kantenwert Γ als Maß für die Entscheidung, welche der Strukturlinien S der Urgeometrie C mechanisch relevant und welche der Strukturlinien S der Urgeometrie C mechanisch nicht relevant sind. Als relevant werden diejenigen der Strukturlinien S eingestuft, die auf wenigstens einem Linienpunkt, vorzugsweise mehreren Linienpunkten, eine lokale Neigung γ aufweisen, die wenigstens so groß wie der globale Kantenwert Γ ist oder sind. Von den Strukturlinien S kann in einer Weiterbildung auch ein Abschnitt oder können mehrere Abschnitte unterdrückt werden. Die lokalen Neigungen γ werden vorzugsweise jeweils in vorgegebenen Abständen oder auf Punkten der jeweiligen Strukturlinie S bestimmt, die in den Geometriedaten G enthalten sind.

Der vom Strukturanalysator reduzierte Datensatz der Geometriedaten G kann bereits die fertige Referenzgeometrie R vollständig beschreiben. Allerdings kann die als unmittelbares Ergebnis des vom Strukturanalysator durchgeführten Reduktionsprozesses erzeugte Referenzgeometrie R von einem Konstrukteur vorsorglich kontrolliert und falls erforderlich manuell nachbearbeitet werden. Für die manuelle Nachbearbeitung wird die Referenzgeometrie R optisch dargestellt, so dass der Konstrukteur beispielsweise erkennen kann, ob in der Referenzgeometrie R zumindest die ihm als wesentlich bekannten Strukturlinien S der Urgeometrie C enthalten sind. Gegebenenfalls kann der Konstrukteur manuell nachträglich eine zu Unrecht unterdrückte Strukturlinie S wieder in die Referenzgeometrie R einfügen. Falls eine manuelle Nachbearbeitung durchgeführt wurde und zu einer Änderung der maschinell erzeugten Referenzgeometrie R geführt hat, wird die nachbearbeitete Referenzgeometrie R als die Referenzgeometrie R verstanden und für die Vernetzung verwendet.

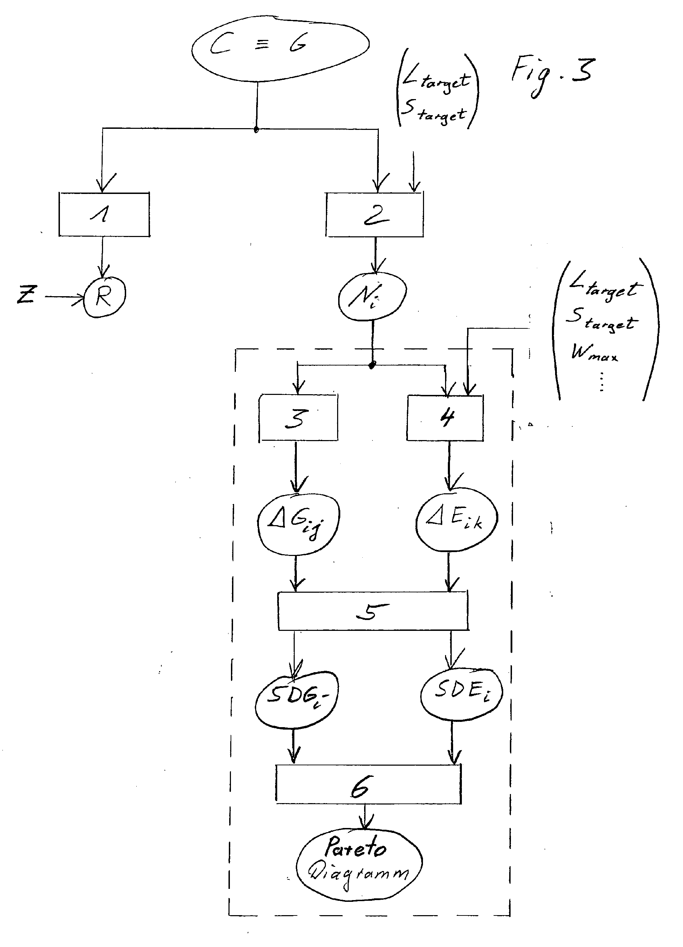

Das Verfahren der Vernetzung ist in Figur 3 in einem Ablaufdiagramm dargestellt. Der Strukturanalysator ist mit 1 und der Vernetzungsprozessor mit 2 bezeichnet. Der Vernetzungsprozessor 2 kann ein in Bezug auf das Computersystem interner Vernetzungsprozessor oder ein externer Vernetzungsprozessor sein, der über eine für einen maschinellen automatischen Datenaustausch geeignete Schnittstelle mit dem Computersystem verbunden ist. Der Strukturanalysator 1 ist vorzugsweise im Computersystem implementiert, kann grundsätzlich aber extern in einem vorgeordneten Computersystem implementiert sein. Bei externer Implementierung des Strukturanalysators 1 weist das Computersystem eine Schnittstelle für einen Datenaustausch mit dem Strukturanalysator 1 auf, wobei dieser Datenaustausch wie auch im Falle eines extern implementierten Vernetzungsprozessors 2 allein darin bestehen kann, dass das Computersystem die vom Strukturanalysator 1 oder dem Vernetzungsprozessor 2 erzeugten Daten nur empfängt, ein Datenaustausch also nur in eine Richtung stattfindet. Ein bidirektionaler Datenaustausch kann aber vorteilhaft sein, um beispielsweise in den Analyseprozess des Strukturanalysators 1 oder in den Vernetzungsprozess des Vernetzungsprozessors 2 eingreifen zu können, beispielsweise durch Generierung von Parametersätzen für Elementkriterien.

Der Strukturanalysator 1 generiert aus den die Urgeometrie C repräsentierenden Geometriedaten G die Referenzgeometrie R, die wie vorstehend erläutert erforderlichenfalls nachbearbeitet wird, was durch den Zugriffspfeil Z angedeutet werden soll.

Dem Vernetzungsprozessor 2 werden nicht nur die Geometriedalen G, sondern zusätzlich Vernetzungsparameter aufgegeben. Die Vernetzungsparameter können insbesondere in Form eines oder mehrerer Zielwerte oder eines oder mehrerer Grenzwerte vorgegeben werden, beispielsweise als Zielwert L_{target} für die Kantenlängen der finiten Elemente oder als oberer Grenzwert für die Anzahl dreiseitiger Elemente oder als Zielwert für die Streckung (aspect ratio) der finiten Elemente, um nur Beispiele zu nennen. Als Vernetzungsparameter sind stellvertretend für weitere oder gegebenenfalls auch andere eine anzustrebende Zielkantenlänge L_{target} und Ziel-Streckung S_{target} angegeben. Im Beispielfall generiert der Vernetzungsprozessor 2 somit ein Netz Nᵢ aus finiten Elementen, die die vorgegebenen Vernetzungsparameter erfüllen, soweit dies möglich ist. Der Vernetzungsprozessor 2 generiert nicht nur ein einziges Netz, sondern generiert automatisch entsprechend einer Vorgabe oder eines Abbruchkriteriums eine Vielzahl von Netzen Nᵢ, die sich voneinander unterscheiden.

Die Generierung unterschiedlicher Netze Nᵢ kann so vonstatten gehen, dass ein Parameterwertgenerator, beispielsweise ein Zufallsgenerator oder ein deterministischer Parameterwertgenerator, der integraler Bestandteil des Vernetzungsprozessors 2 oder anderweitig im Computersystem implementiert sein kann, die Zielwerte der Vernetzungsparameter innerhalb vorgegebener Grenzen, beispielhaft einer minimalen und einer maximalen Kantenlänge Lₘᵢₙ und Lₘₐₓ, variiert und für jeden Satz der variierten Parameterwerte jeweils eines der Netze Nᵢ generiert.

Die generierten Netze Nᵢ werden jeweils einer Auswertungseinrichtung des Computersystems aufgegeben. Die Auswertungseinrichtung umfasst einen implementierten Geometrieanalysator 3 und einen implementierten Elementkriterienanalysator 4. Der Geometrieanalysator 3 vergleicht jedes der generierten Netze Nᵢ mit der Referenzgeometrie R und ermittelt aus dem Vergleich Geometrieabweichungen ΔGᵢⱼ. Hier sind i der Laufindex für die Netze Nᵢ und j der Laufindex für die Orte j, an denen die Geometrieabweichungen des jeweils untersuchten Netzes Nᵢ ermittelt werden.

Der Elementkriterienanalysator 4 vergleicht die finiten Elemente jedes der Netze Nᵢ jeweils mit einem Satz von vor dem Start des Verfahrens vorgegebenen Vergleichswerten von Elementkriterien, beispielhaft der Zielkantenlänge L_{target}, der Ziel-Streckung S_{target} und einer maximalen Verwindung Wₘₐₓ, und ermittelt aus dem Vergleich Elementabweichungen ΔEᵢₖ. Der Index i steht wieder für das untersuchte Netz Nᵢ und der Index k für das jeweils betrachtete Element FEₖ des Netzes N;. Bei diesen Elementen FEₖ wird jeweils wenigstens eines und werden vorzugsweise mehrere ausgewählte oder noch bevorzugter alle der unterschiedlichen Elementenkriterien untersucht und mit dem jeweiligen vorgegebenen Kriterien-Vergleichswert verglichen und hieraus die Elementabweichungen ΔEᵢₖ gebildet. Werden zum Beispiel als Vergleichswerte unter anderem eine Zielkantenlänge L_{target}, eine Zielstreckung S_{target} und eine maximale Verwindung Wₘₐₓ vorgegeben, beispielsweise L_{target} = 10 mm, S_{target} = 1 und Wₘₐₓ = 30°, und wird für eine der Kanten eines finiten Elements eine Länge von 3 mm und für eine weitere Kante des gleichen Elements eine Länge von 12 mm sowie eine Verwindung von 35° und eine Streckung 12/3 = 4 ermittelt, ergeben sich für dieses Element eine erste Elementabweichung ΔEᵢₖ = 7 mm für die Unterschreitung und eine zweite Elementabweichung ΔEᵢₖ = 2 mm für die Überschreitung des Vergleichswerts L_{target}, eine dritte Elementabweichung ΔEᵢₖ = 5° für die Überschreitung des Vergleichswerts Wₘₐₓ und eine vierte Elementabweichung ΔEᵢₖ = 3 für die Überschreitung von S_{target}. Diese Elementabweichungen fließen in den Elementkriteriengütewert SDEᵢ des Netzes Nᵢ ein. Auf diese Weise werden zumindest eine größere Anzahl, vorzugsweise alle der finiten Elemente FEₖ des Netzes Nᵢ untersucht und jeweils die Elementabweichungen ΔEᵢₖ ermittelt. Vorzugsweise wird zusätzlich für jedes der Elemente FEₖ aus den jeweils mehreren Elementabweichungen ΔEᵢₖ ein Elementkennwert gebildet, der das jeweilige finite Element FEₖ charakterisiert.

Die Geometrieabweichungen ΔGᵢⱼ werden mittels einer implementierten Verdichtungseinrichtung 5 der Auswertungseinrichtung zu einem die Geometrietreue des jeweiligen Netzes Nᵢ charakterisierenden Geometriegütewert SDGᵢ verdichtet. Beispielhaft wird aus der für das jeweilige Netz Nᵢ ermittelten Menge der Geometrieabweichungen ΔGᵢⱼ die Standardabweichung als der Geometriegütewert SDGᵢ ermittelt. Auch für die Elementabweichungen ΔEᵢₖ wird jeweils als Elementkriteriengütewert SDEᵢ des jeweiligen Netzes Nᵢ beispielhaft die Standardabweichung ermittelt. Der von der Verdichtungseinrichtung 5 durchgeführte Verdichtungsprozess liefert somit pro Netz Nᵢ jeweils ein Paar von Gütewerten (SDGᵢ, SDEᵢ).

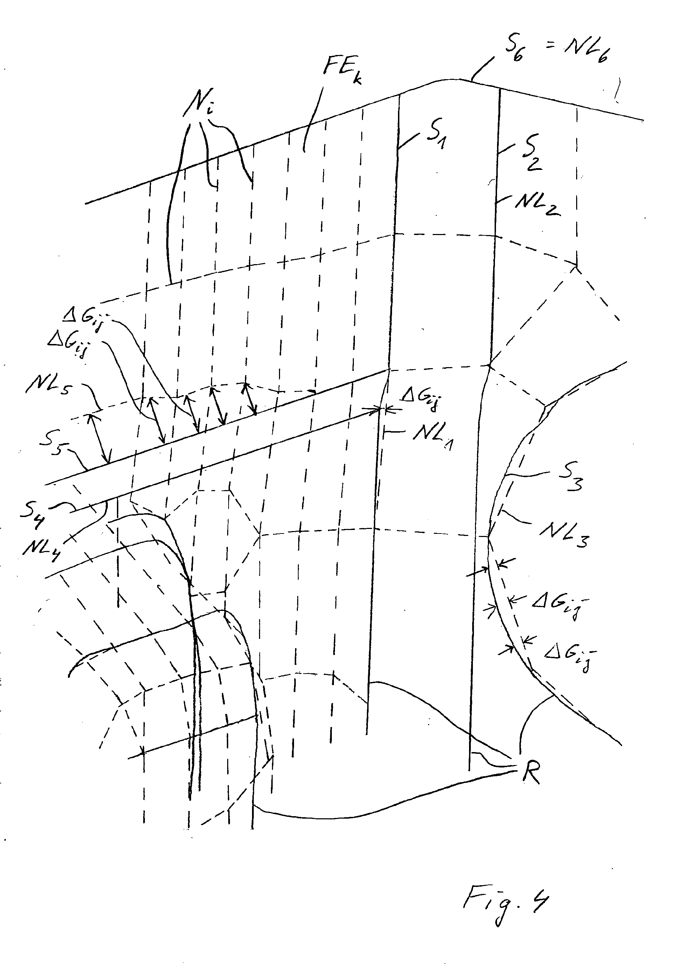

In Figur 4 sind die Referenzgeometrie R und eines der generierten Netze Nᵢ in einer Überlagerung dargestellt. Die Referenzgeometrie R wird durch die durchgezogenen Linien und das generierte Netz Nᵢ durch die strichlierten Linien repräsentiert. Einige der Strukturlinien S der Referenzgeometrie R und einige der Netzlinien NL des generierten Netzes Nᵢ sind zu Erläuterungszwecken indiziert. Die Strukturlinien S₃ und S₆ entsprechend jeweils einem Rand des Bauteils. Die Strukturlinien S₂, S₄ und S₆ sind im generierten Netz Nᵢ genau vorhanden. Diesen Strukturlinien entsprechen die Netzlinien NL₂, NL₄ und NL₆. Die Netzlinie NL₁ entspricht der Strukturlinie S₁ zumindest im Wesentlichen, sie weicht lediglich in einem kurzen Abschnitt geringfügig von der Strukturlinie S₁ um ΔGᵢⱼ ab. Die Strukturlinie S₃ wird durch den Linienzug NL₃ angenähert, mit allerdings deutlichen Geometrieabweichungen ΔGᵢⱼ längs der Strukturlinie S₃. Die Strukturlinie S₅ hat im generierten Netz Nᵢ über einen größeren Teil ihrer Länge keine Entsprechung. Die für den Vergleich und die Ermittlung der Geometrieabweichung(en) ΔGᵢⱼ verwendbare nächste Netzlinie NL₅ weist zur Strukturlinie S₅ erhebliche Abweichungen, nämlich Abstände ΔGᵢⱼ auf. Die längs der jeweiligen Strukturlinie, beispielsweise S₅, in regelmäßigen Abständen ermittelten Geometrieabweichungen ΔGᵢⱼ werden von der Verdichtungseinrichtung 5 zum Geometriegütewert SDGᵢ verdichtet.

Die Gütewertepaare (SDGᵢ, SDEᵢ) der generierten Netze Nᵢ werden in einer implementierten Vergleichseinrichtung 6 der Auswertungseinrichtung einer Vergleichsoperation unterzogen, in der die Geometriegütewerte SDGᵢ miteinander und die Elementkriteriengütewerte SDEᵢ miteinander verglichen werden. In der Vergleichsoperation werden diejenigen Gütewertepaare (SDGᵢ, SDEᵢ) und somit die zugehörigen Netze Nᵢ identifiziert, für die nicht zugleich der Geometriegütewert SDGᵢ und der Elementkriteriengütewert SDEᵢ schlechter sind als bei wenigstens einem anderen der Netze Nᵢ. Beim Vergleich zweier Netze, nämlich beim Vergleich der beiden Gütewertepaare der zwei Netze, gehen ein besserer Geometriegütewert mit einer größeren Geometrietreue zum Referenznetz R und somit zum physikalischen Bauteil und ein besserer Elementkriteriengütewert mit einer höheren Eignungsgrad für die FEM-Simulation einher. Im Beispielfall, in dem die Gütewerte als Standardabweichungen SDGᵢ und SDEᵢ errechnet werden, bedeutet ein im Vergleich zweier Netze größerer Geometriegütewert, dass das Netz mit dem größeren Geometriegütewert eine geringere Geometrietreue als das Netz mit dem geringeren Geometriegütewert aufweist. Analog ist die Situation beim Elementkriteriengütewert, d.h. das Netz mit dem im Vergleich zweier Netze größeren Elementkriteriengütewert weist für die FEM-Simulation einen niedrigeren Eignungsgrad als das Netz mit dem geringeren Elementkriteriengütewert auf. Theoretisch optimal wären ein Geometriegütewert SDGᵢ = 0 und ein Elementkriteriengütewert SDEᵢ = 0.

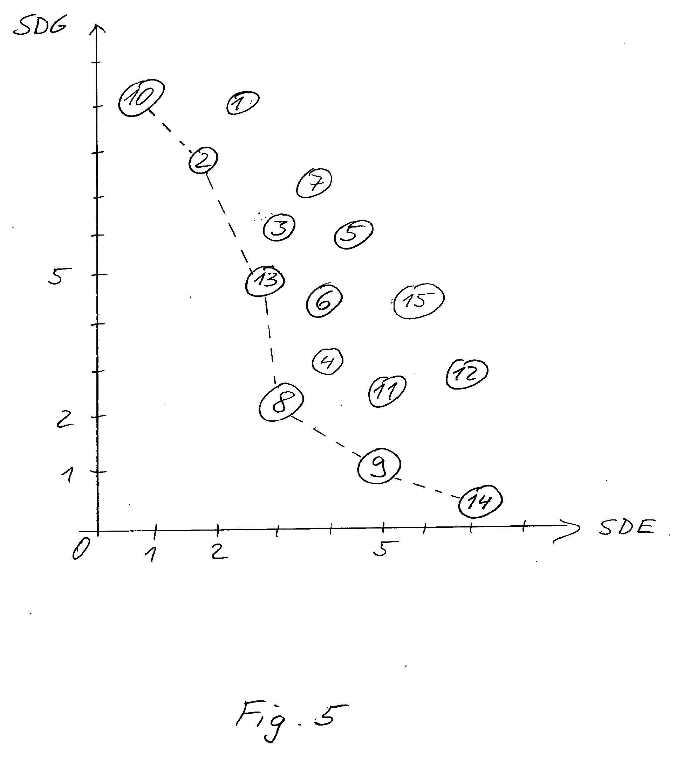

Die Auswertungseinrichtung ordnet die Gütewertepaare (SDGᵢ, SDEᵢ) in einem Diagramm mit dem Geometriegütewert SDG als erster Achse und dem Elementkriteriengütewert als SDE als zweiter Achse an, wie in Figur 5 veranschaulicht. Dieses Diagramm kann beispielsweise auf einem Bildschirm des Computersystems dargestellt oder mittels einer Druckvorrichtung ausgedruckt werden. Ein entsprechendes Ausgabemedium kann Bestandteil des Computersystems und mit der Auswertungseinrichtung per maschinell automatischem Datenaustausch verbunden sein. Alternativ oder zusätzlich können die in einer Datenspeichereinrichtung des Computersystems gespeicherten Gütewertepaare (SDGᵢ, SDEᵢ) auch mittels eines im Verhältnis zum Computersystem externen Ausgabemediums ausgegeben oder für eine weitere maschinelle Datenverarbeitung bereitgestellt werden, beispielsweise durch Ausgabe an eine Schnittstelle für Datenaustausch, wie etwa eine USB-Schnittstelle oder eine Schnittstelle für drahtlosen Datenaustausch.

Im Diagramm der Figur 5 sind beispielhaft 15 unterschiedliche Netze Nᵢ in Form ihrer Gütewertepaare (SDGᵢ, SDEᵢ) angeordnet, wobei diese Gütewertepaar nur mit ihrem das jeweilige Netz Nᵢ anzeigenden Index i dargestellt sind. Die Auswertungseinrichtung stellt beim Vergleich beispielsweise der Netze Nᵢ und N₂ fest, dass das Netz N₂ einen niedrigeren und daher besseren Geometriegütewert und auch einen niedrigeren und daher besseren Elementkriteriengütewert als das Netz N₁ aufweist. Das Netz N₂ wird daher gegenüber dem Netz N₁ favorisiert. Das Netz N₃ beispielsweise ist dem Netz N₂ hinsichtlich des Geometriegütewerts überlegen, aber hinsichtlich des Elementkriteriengütewerts unterlegen, so dass der Vergleich der beiden Netze N₂ und N₃ noch nicht unmittelbar einen Favoriten liefert. Erst der Vergleich mit dem Netz N₈ und auch der Vergleich mit dem Netz N₁₃ identifiziert das Netz N₃ als ein unterlegenes, nicht favorisiertes Netz. Das Netz N₈ weist gegenüber dem Netz N₃ den besseren Geometriegütewert und einen gleichen Elementkriteriengütewert auf und ist dem Netz N₃ daher vorzuziehen. Das gleiche gilt im Vergleich mit dem Netz N₁₃. Zwischen den Netzen N₈ und N₁₃ liefert der unmittelbare Vergleich hingegen keinen direkten Favoriten, da das Netz N₈ dem Netz N₁₃ hinsichtlich des Geometriegütewerts zwar überlegen, aber hinsichtlich des Elementkriteriengütewerts unterlegen ist. Die Vergleichsoperation liefert ausgedrückt im Diagramm der Figur 5, dem sogenannten Pareto-Diagramm, eine Gruppe von zu favorisierenden Netzen, im Diagramm sind dies längs der SDE-Achse die Netze N₁₀, N₂, N₁₃, N₈, N₉ und N₁₄. Diese Netze bilden eine sogenannte Pareto-Front, die strichliiert angedeutet ist, während die übrigen der beispielhaft 15 Netze N₁ bis N₁₅ nach der hier implementierten Methode von Pareto als unterlegene und daher nicht mehr weiter zu verwendende Netze eingestuft werden.

Das letztlich für die FEM-Simulation zu verwendende Netz kann in einem nachfolgenden Schritt beispielsweise nach dem Kriterium ausgewählt werden, dass es zum Ursprung des Diagramms den geringsten Abstand aufweist. In der beispielhaften Darstellung der Figur 5 wäre dies das Netz N₈. Dieser dem Ausscheidungsverfahren nach Pareto nachgelagerte Entscheidungsschritt kann noch innerhalb der Auswertungseinrichtung implementiert und ebenfalls automatisiert sein, so dass das Verfahren unmittelbar das an die FEM-Simulation zu übergebende Netz, hier das Netz N₈ identifiziert und, optional, auch gleich an die FEM-Simulation automatisch überträgt.

### Nomenklatur:

- 1: Struktur(kanten)analysator
- 2: Vernetzungsprozessor
- 3: Geometrieanalysator
- 4: Elementkriterienanalysator
- 5: Verdichtungseinrichtung
- 6: Vergleichseinrichtung

- C: Urgeometrie
- F_{1,2}: Flächennormale
- G: Geometriedaten
- i: Laufindex der generierten Netze
- j: Laufindex der Knotenpunkte des jeweiligen Netzes Nᵢ
- k: Laufindex der finiten Elemente
- L: Kantenlänge
- Nᵢ: generiertes Netz
- NL: Netzlinie
- R: Referenzgeometrie
- S: Strukturlinie
- S_{target}: Ziel-Streckung
- W: Verwindung
- X, Y, Z: Koordinatensystem für C, R und Nᵢ
- ΔEᵢₖ: Elementkriterienabweichung
- ΔGᵢⱼ: Geometrieabweichung
- SDGᵢ: Geometriegütewert
- SDEᵢ: Elementkriteriengütewert
- γ: lokale Neigung
- Γ: globaler Kantenwert

## Patentansprüche

1. Verfahren zur Vernetzung einer durch maschinell verarbeitbare Geometriedaten (G) repräsentierten CAD-Urgeometrie (C) eines Bauteils in einem Computersystem, das einen Vernetzungsprozessor (2) zur maschinellen Generierung eines Netzes (Nᵢ) mit finiten Elementen (FE) oder eine Schnittstelle für maschinellen Datenaustausch mit einem externen Vernetzungsprozessor, eine Auswertungseinrichtung (3-6) zur maschinellen Datenverarbeitung und eine Datenspeichereinrichtung aufweist, mit wenigstens den folgenden Verfahrensschritten:
(a) dem Vernetzungsprozessor (2) werden Vernetzungsparameter (L_{target}) und die Geometriedaten (G) vorgegeben,
(b) der Vernetzungsprozessor (2) generiert aus den Geometriedaten (G) unter Berücksichtigung der Vernetzungsparameter (L_{target}) mehrere Netze (Nᵢ) mit finiten Elementen (FE) jeweils in Form maschinell verarbeitbarer Netzdaten,
(c) die Auswertungseinrichtung (3-6) vergleicht die generierten Netze (Nᵢ) jeweils mit einer für das Bauteil erstellten Referenzgeometrie (R), vorzugsweise einer aus der Urgeometrie (C) durch Vereinfachung derselben erstellten Referenzgeometrie (R),
(d) ermittelt für jedes der Netze (Nᵢ) aus dem Vergleich Geometrieabweichungen (ΔGᵢⱼ) von der Referenzgeometrie (R)
(e) und bildet für jedes der Netze (Nᵢ) aus dessen Geometrieabweichungen (ΔGᵢⱼ) einen das Ausmaß der Geometrieabweichungen (ΔGᵢⱼ) des jeweiligen Netzes (Nᵢ) kennzeichnenden Geometriegütewert (SDGᵢ),
(f) die Auswertungseinrichtung (3-6) ermittelt für Elemente (FE) jedes der Netze (Nᵢ) die Größe einer Elementabweichung (ΔEᵢₖ) von wenigstens einem als Vergleichswert (L_{target}, S_{target}, Wₘₐₓ) vorgegebenen Elementkriterium,
(g) bildet für jedes der Netze (Nᵢ) aus dessen Elementabweichungen (ΔEᵢₖ) einen das Ausmaß der Elementabweichungen (ΔEᵢₖ) des jeweiligen Netzes (Nᵢ) kennzeichnenden Elementkriteriengütewert (SDEᵢ)
(h) und speichert die Paare der Geometrie- und Elementkriteriengütewerte (SDGᵢ, SDEᵢ) unter Zuordnung zum jeweils zugehörigen Netz (Nᵢ) in der Datenspeichereinrichtung für eine weitere maschinelle Auswertung oder eine maschinelle Ausgabe auf ein Ausgabemedium.

2. Verfahren nach dem vorhergehenden Anspruch, bei dem die Auswertungseinrichtung (3-6) maschinell durch Vergleich der Geometriegütewerte (SDGᵢ) und Elementkriteriengütewerte (SDEᵢ) diejenigen der generierten Netze (Nᵢ) ermittelt, die nicht zugleich einen schlechteren Geometriegütewert (SDGᵢ) und einen schlechteren Elementkriteriengütewert (SDEᵢ) als wenigstens ein anderes der generierten Netze (Nᵢ) haben, und kennzeichnet die ermittelten Netze (Nᵢ) als favorisierte Netze.

3. Verfahren nach einem der vorhergehenden Ansprüche, bei dem das Computersystem die generierten Netze (Nᵢ) oder, falls der Vergleich nach dem vorhergehenden Anspruch durchgeführt wird und mehrere favorisierte Netze (Nᵢ) liefert, zumindest die favorisierten Netze (Nᵢ), repräsentiert durch den Geometriegütewert (SDGᵢ) und den Elementkriteriengütewert (SDEᵢ) des jeweiligen Netzes, in einem Koordinatensystem (Pareto-Diagramm) mit dem Geometriegütewert (SDG) als erster Koordinatenachse und dem Elementkriteriengütewert (SDE) als zweiter Koordinatenachse anordnet und das Koordinatensystem optisch darstellt.

4. Verfahren nach einem der vorhergehenden Ansprüche, bei dem das Computersystem die Vernetzungsparameter (L_{target}) automatisch variiert, vorzugsweise nach einer Vorgabe in determinierter Weise oder mittels eines Zufallsgenerators, mehrere Sätze von variierten Parameterwerten der Vernetzungsparameter bildet und für diese unterschiedlichen Sätze von Werten jeweils eines der Netze (Nᵢ) generiert.

5. Verfahren nach einem der vorhergehenden Ansprüche, bei dem die Urgeometrie (C) in einem dreidimensionalen Koordinatensystem (X, Y, Z) vorgegeben wird, die Geometriedaten (G) Strukturlinien (S) des Bauteils bestimmen und die Strukturlinien (S) zumindest Kanten des Bauteils repräsentieren.

6. Verfahren nach dem vorhergehenden Anspruch, bei dem die Geometriedaten (G) einem computerimplementierten Strukturanalysator (1), der vorzugsweise im Computersystem implementiert ist, aufgegeben werden, und der Strukturanalysator (1) für die im Vergleich mit der Urgeometrie (C) vereinfachte Referenzgeometrie (R) Referenzlinien (S) erstellt, indem er die Strukturlinien (S) der Urgeometrie (C) durch maschinelle Verarbeitung der Geometriedaten (G) nach wenigstens einem vorgegebenen Entscheidungskriterium in mechanisch relevante und mechanisch nicht relevante Strukturlinien (S) einteilt und nur die relevanten Strukturlinien (S) für die Referenzgeometrie (R) als Referenzlinien (S) übernimmt.

7. Verfahren nach einem der zwei vorhergehenden Ansprüche, bei dem der Strukturanalysator (1) zumindest einen repräsentativen größeren Teil der durch die Geometriedaten (G) bestimmten Strukturlinien (S), vorzugsweise alle Strukturlinien der Urgeometrie (C) abfährt, für diese Strukturlinien (S) jeweils die Größe einer lokalen Neigung (γ) der Urgeometrie (C) ermittelt, aus den lokalen Neigungen (γ) einen für die Urgeometrie (C) im Ganzen charakteristischen globalen Kantenwert (Γ) bildet, die lokalen Neigungen (γ) jeweils mit dem globalen Kantenwert (Γ) vergleicht und von den abgefahrenen Strukturlinien (S) nur diejenigen mit der jeweiligen lokalen Neigung (γ) in die Referenzgeometrie (R) übernimmt, an denen die lokale Verwindung (γ) wenigstens so groß wie der globale Kantenwert (Γ) ist.

8. Verfahren nach einem der drei vorhergehenden Ansprüche, bei dem längs der Strukturlinien (S) jeweils zwei Flächen der Urgeometrie (C) aneinander stoßen und die für die Strukturlinien (S) ermittelten lokalen Neigungen (γ) jeweils der Winkel sind, den eine Flächennormale (F₁) der einen und eine Flächennormale (F₂) der anderen der längs der jeweiligen Strukturlinie (S) aneinander stoßenden Flächen miteinander einschließen.

9. Verfahren nach einem der vorhergehenden Ansprüche, bei dem die Auswertungseinrichtung (3-6) für Referenzpunkt oder Referenzlinien (S) der Referenzgeometrie (R) jeweils einen Abstand zu wenigstens einem nächst gelegenen Knotenpunkt oder einer nächstgelegenen Netzlinie (NL) des jeweiligen generierten Netzes (Nᵢ) ermittelt und die so ermittelten Abstände als die Geometrieabweichungen (ΔGᵢⱼ) bei der Bestimmung des Geometriegütewerts (SDGᵢ) des jeweiligen Netzes (Nᵢ) verwendet.

10. Verfahren nach einem der vorhergehenden Ansprüche, bei dem die Auswertungseinrichtung (3-6) für eine Referenzlinie (S) der Referenzgeometrie (R) durch Vergleich mit jeweils einem der generierten Netze (Nᵢ) ermittelt, ob das jeweilige Netz (Nᵢ) Knotenpunkte aufweist, die in diesem Netz (Nᵢ) die Referenzlinie (S) repräsentieren und dadurch ersetzen und, falls die Existenz derartiger Knotenpunkte festgestellt wird, für wenigstens einen dieser Knotenpunkte, vorzugsweise für jeden dieser Knotenpunkte, der Abstand von der Referenzlinie (S) ermittelt wird.

11. Verfahren nach einem der vorhergehenden Ansprüche, bei dem die Auswertungseinrichtung (3-6) für jedes der Elemente (FE), für die wenigstens eine Elementabweichung (ΔEᵢₖ) ermittelt wurde, aus dessen Elementabweichung(en) (ΔEᵢₖ) einen einzigen für das jeweilige Element (FE) charakteristischen Elementkennwert bildet, vorzugsweise diesen mit dem Elementkriteriengütewert (SDEᵢ) des jeweiligen Netzes (Nᵢ) vergleicht und diejenigen Elemente (FE) kennzeichnet, deren Elementkennwert den Elementkriteriengütewert (SDEᵢ) des jeweiligen Netzes (Nᵢ) dem Betrage nach übersteigt.

12. Verfahren nach einem der vorhergehenden Ansprüche und wenigstens einem der folgenden Merkmale:
(i) die Vernetzungsparameter (L_{target}) enthalten einen Zielwert für eine Kantenlänge der finiten Elemente (FE);
(ii) die Elementkriterien enthalten als Vergleichswert eine Zielkantenlänge (L_{target}) oder eine maximale Verwindung (Wₘₐₓ) oder eine Ziel-Streckung (S_{target}) der finiten Elemente (FE), wobei die Verwindung vorzugsweise ein Winkel ist, den eine Flächennormale (F₁) eines Teilbereichs und eine Flächennormale (F₂) eines anderen Teilbereichs des jeweiligen Elements (FE) miteinander einschließen.

13. Verfahren nach einem der vorhergehenden Ansprüche, bei dem die Urgeometrie (C) einer Karosserie, eines Karosserieteils oder eines Anbauteils wie etwa einer Tür, Motorhaube, Heckklappe, eines Kofferraumdeckels, Kotflügels oder Schiebedachs eines Kraftfahrzeugs vernetzt wird.

14. Computerprogrammprodukt, das für die Ausführung des Verfahrens nach einem der vorhergehenden Ansprüche in das Computersystem ladbaren Programmcode für die maschinelle automatische Ausführung wenigstens der Verfahrensschritte (c) bis (h) umfasst, um nach Implementierung mit dem vorzugsweise bereits implementierten Vernetzungsprozessor (2) das Verfahren ausführen zu können.

15. Computersystem mit implementiertem Programmcode zur Vernetzung einer durch maschinell verarbeitbare Geometriedaten (G) repräsentierten CAD-Urgeometrie (C) eines Bauteils, das Computersystem umfassend:
(a) entweder einen internen Vernetzungsprozessor (2) zur maschinellen Generierung von Netzen (Nᵢ) finiter Elemente (FE) oder nur eine Schnittstelle für maschinellen Datenaustausch mit einem externen solchen Vernetzungsprozessor (2),
(b) eine Auswertungseinrichtung (3-6), der die generierten Netze (Nᵢ) repräsentierende Netzdaten zur maschinellen Datenverarbeitung zuführbar sind,
(c) eine Datenspeichereinrichtung zur Speicherung zumindest von Daten der Auswertungseinrichtung (3-6), vorzugsweise auch der vom Vernetzungsprozessor (2) generierten Netzdaten der Netze (Nᵢ),
(d) und ablauffähig implementierten Programmcode zur Ausführung zumindest der Verfahrensschritte (c) bis (h) des Verfahrens nach einem der vorhergehenden Ansprüche,
(e) optional einen Strukturanalysator (1) zur Erstellung der Referenzgeometrie (R) durch Vereinfachung der Urgeometrie (C), vorzugsweise den Strukturanalysator (1) nach einem der Ansprüche 6 und 7.
